# FASCICULE DE BREVET EUROPEEN

(11) **EP 0 996 064 B1**
(45) Date de publication et mention de la délivrance du brevet: **17.12.2003**
(21) Numéro de dépôt: 99410133.5
(22) Date de dépôt: 13.10.1999
(51) Int. Cl.: G06F 11/20, G11C 16/04

(54) **Cellule mémoire à programmation unique**
Einmalig programmierbare Speicherzelle
One-time programmable memory cell

(30) Priorité: 16.10.1998 FR 9813168
(43) Date de publication de la demande: 26.04.2000
(73) Titulaire: STMicroelectronics S.A., 92120 Montrouge (FR)
(72) Inventeur: Ferrant, Richard, 38330 Saint Ismier (FR); Jacquet, François, 38000 Grenoble (FR)
(74) Mandataire: de Beaumont, Michel

(56) Documents cités:
- US-A- 3 744 036
- US-A- 5 602 777

## Description

La présente invention concerne le domaine des cellules mémoire à programmation unique (OTP), qui sont susceptibles de conserver un état programmé même après disparition de l'alimentation du circuit. L'invention concerne plus particulièrement une telle cellule mémoire réalisée à partir d'un transistor MOS à canal P dont la grille est laissée flottante.

Un exemple d'application des cellules à programmation unique est la réalisation d'éléments de redondance qui sont généralement prévus dans des mémoires réalisées sous la forme d'un ou plusieurs réseaux matriciels en circuit intégré, pour remplacer fonctionnellement un élément de mémoire défaillant. Le rôle des cellules à programmation unique est de programmer le décalage des colonnes ou rangées de la mémoire lors de l'utilisation d'un élément de redondance pour pallier à la défaillance d'une colonne ou d'une rangée du réseau.

Dans ce genre d'application, on utilise soit des éléments fusibles, par exemple par laser, soit des cellules mémoire à programmation unique du type EEPROM, ou du type à transistor à grille flottante auxquelles s'applique la présente invention.

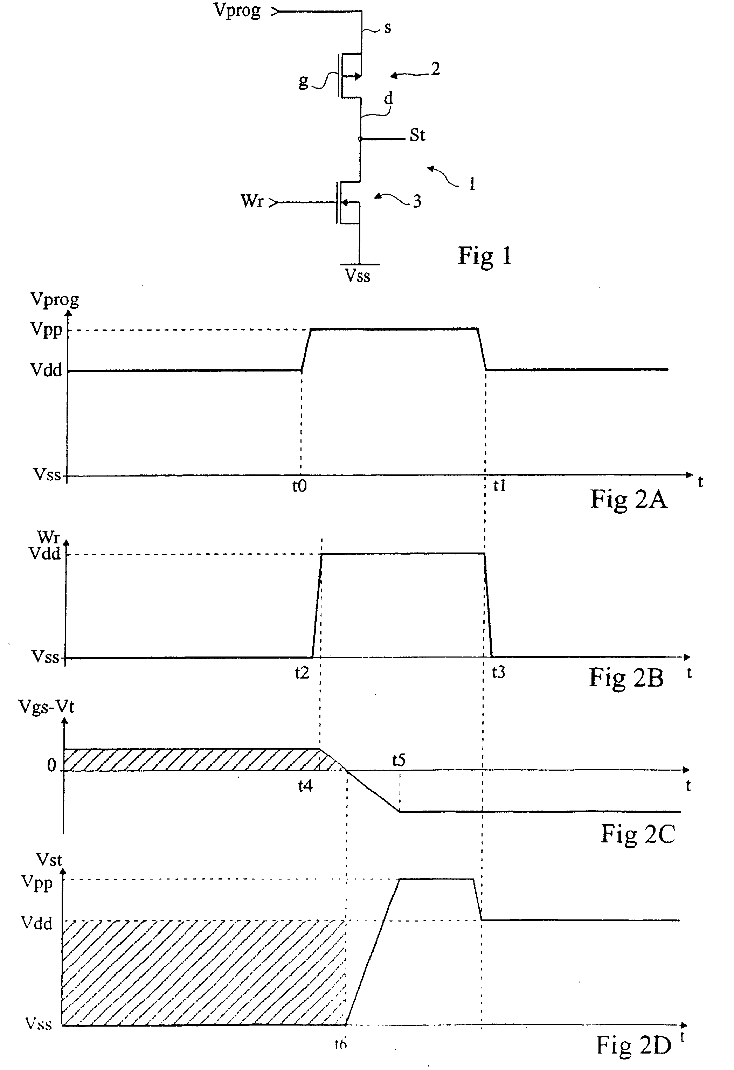

La figure 1 représente, de façon schématique, un exemple de cellule mémoire 1 à programmation unique du type auquel s'applique la présente invention.

Cette cellule est essentiellement constituée d'un transistor MOS 2 à canal P à simple grille g laissée flottante. La source s du transistor 2 reçoit une tension Vprog ayant un potentiel de repos et un potentiel de programmation qui seront exposés ci-après. Le transistor 2 est connecté en série avec un transistor de programmation 3 dont la grille reçoit un signal Wr de programmation et dont la source est connectée à un potentiel bas vss d'alimentation, généralement la masse. Le transistor de programmation 3 est un transistor à canal N dont le drain est connecté au drain d du transistor mémoire 2 qui constitue un noeud St de stockage portant l'état "0" ou "1" mémorisé.

Par soucis de simplification, un seul transistor 3 de programmation a été représenté à la figure 1. En pratique, chaque cellule mémoire comporte généralement deux transistors de programmation montés en série et dont les signaux de commande varient légèrement l'un par rapport à l'autre. Toutefois, cette distinction n'est pas fondamentale pour l'invention.

Une cellule mémoire à transistor à grille flottante utilise le phénomène, connu sous la dénomination "d'électrons chauds" où, sous l'effet d'une différence de potentiel entre la source et le drain du transistor, des électrons traversent l'oxyde de grille constitutif du transistor 2 et restent stockés dans la grille en silicium polycristallin sans pouvoir s'évacuer, de sorte qu'ils fixent un état passant du transistor 2 par modification apparente de sa tension de seuil.

Le fonctionnement d'une cellule 1 représentée à la figure 1 est illustré par les figures 2A à 2D qui représentent, sous forme de chronogrammes, un exemple d'allure de signaux caractéristiques de la cellule mémoire. La figure 2A représente l'allure de la tension Vprog appliquée sur la source s du transistor 2. La figure 2B représente l'allure du signal de programmation Wr. La figure 2C représente l'allure de la tension Vgs-Vt, où Vgs représente la tension grille-source du transistor 2 et où Vt représente sa tension seuil. La figure 2D représente l'allure du potentiel Vst au noeud de stockage St.

On suppose que la cellule 1 est initialement vierge, c'est-à-dire que le noeud de stockage St est, de façon naturelle à l'issu de la fabrication, dans un état "bas" en raison du caractère bloqué du transistor 2. Lorsque le circuit mémoire est mis sous tension, la source s du transistor 2 est portée au potentiel positif Vdd d'alimentation du circuit qui constitue, pour la cellule mémoire 1, un potentiel d'alimentation de repos. En l'absence de programmation de la cellule, le signal Wr reste à l'état bas (sensiblement au potentiel Vss) de sorte que le transistor de programmation 3 reste bloqué. Il en découle que la tension Vgs-Vt est positive ou nulle de sorte que le potentiel Vst est flottant.

On notera que, par soucis de simplification, on fait référence aux potentiels Vdd et Vss sans tenir compte des éventuelles chutes de tensions résistives dans des transistors de commande (non représentés).

On suppose qu'à un instant t0, on souhaite programmer la cellule 1, c'est-à-dire y stocker un état haut de sorte que le noeud St restitue un niveau "1" correspondant sensiblement au potentiel positif Vdd. Pour programmer la cellule 1, le signal Vprog est commuté vers un potentiel Vpp de programmation supérieur au potentiel Vdd. Ce potentiel de programmation Vpp est maintenu sur le signal Vprog jusqu'à un instant t1 correspondant à la fin du cycle de programmation de la cellule 1.

À un instant t2, postérieur à l'instant t0, le signal de programmation Wr est commuté vers le potentiel Vdd pour rendre conducteur le transistor de programmation 3. À partir de l'instant t4 où le transistor 3 est fortement conducteur, le transistor 2 a tendance à devenir conducteur par le fort champ électrique appliqué entre son drain et sa source. Il en découle la génération d'électrons chauds dont certains s'accumulent sur sa grille g. En effet, comme le potentiel de la source s est supérieur à la tension Vdd (nominale) d'alimentation, la tension Vgs-Vt du transistor 2 finit par devenir négative de sorte que celui-ci devient conducteur. Comme la grille g est isolée, ces électrons ne peuvent pas s'évacuer et l'état conducteur du transistor 2 est donc un état stable. Comme l'illustre la figure 2D, dès que la tension Vgs-Vt devient négative (instant t6), la tension du noeud de stockage St se met à croître par la mise en conduction progressive du transistor 2. Le stockage des électrons dans la grille g provoque une diminution de la tension seuil du transistor qui est ici utilisée pour le rendre conducteur de façon stable. On peut considérer qu'à un instant t5, où le noeud St a atteint le potentiel Vpp (en négligeant la chute de tension dans le transistor 2 à l'état passant), la tension grille-source du transistor 2 reste stable.

Le potentiel du signal de programmation Wr est commuté vers un état bas (Vss) à un instant t3 postérieur au temps nécessaire à la programmation de la cellule. La commutation du signal Wr intervient après la remise du signal Vprog au repos (instant t1). A l'instant t1 de retour du signal Vprog à la tension Vdd, le noeud St passe également au potentiel Vdd dans la mesure où le transistor 2 reste passant. Le fait de commuter le signal de programmation Wr postérieurement à la remise à l'état de repos du signal Vprog permet précisément de ramener le potentiel du noeud St au potentiel Vdd.

Une fois que la cellule 1 est dans cet état programmé, cet état reste stable même en cas d'extinction du circuit, c'est-à-dire de coupure de son alimentation, dans la mesure où les électrons de la grille du transistor 2 ne peuvent pas être évacués.

Le niveau de tension Vpp, nécessaire à la programmation d'une telle cellule mémoire, dépend de plusieurs facteurs parmi lesquels, en particulier, la durée d'un cycle de programmation et la dimension unitaire de la technologie de fabrication utilisée qui conditionne également la tension d'alimentation Vdd du circuit.

Ainsi, quand les technologies de fabrication des transistors utilisaient une taille élémentaire de l'ordre de 4 ou 5 µm, la tension de programmation Vpp nécessaire était de l'ordre de 20 à 30V. Ce besoin de tension élevé a, par le passé, motivé le développement de cellules EEPROM qui mettent en oeuvre un effet Fowlder-Nordheim. De telles cellules EEPROM fonctionnent correctement, mais nécessitent un procédé de fabrication particulier alors que la fabrication de transistors à grille flottante peut s'effectuer selon le même procédé que des transistors MOS de commutation (CMOS).

Dans une technologie où la taille élémentaire est de 0, 35 µm, un niveau Vpp de l'ordre de 4,5 à 5 volts suffit pour programmer une cellule utilisant un transistor à grille flottante. Dans une telle technologie, la tension Vdd d'alimentation nominale est de l'ordre de 3,3 volts. Ces niveaux de potentiels conduisent à ce qu'il redevient intéressant de fabriquer des cellules mémoire à programmation unique par une telle technique.

Toutefois, la vitesse à laquelle les électrons chauds s'accumulent dans la grille dépend du niveau de potentiel appliqué sur la source. Plus précisément, la vitesse d'accumulation de ces électrons chauds dépend de la différence de potentiel entre la tension appliquée sur la source du transistor et sa tension seuil qui est liée à la technologie de fabrication.

Ainsi, par exemple, avec une technologie de 0,35 µm une tension Vpp d'environ 4,5 volts nécessite une durée d'environ 100 ms pour atteindre la programmation stable de la cellule, alors qu'une tension Vpp de 5 volts ne nécessite que de 10 ms pour programmer la cellule. Il en découle que le phénomène de stockage d'électrons, dans la grille en silicium polycristallin d'un transistor à grille flottante, intervient au cours du temps sans qu'il soit nécessaire d'appliquer un potentiel supérieur au potentiel nominal d'alimentation sur la source de ce transistor.

Un inconvénient des cellules mémoire à programmation unique utilisant un transistor à grille flottante est donc qu'elles sont susceptibles de prendre un état programmé alors qu'elles ne sont alimentées que par la tension d'alimentation Vdd nominale du circuit. De plus, plus cette tension d'alimentation nominale diminue, plus l'écart de la tension de repos du signal Vprog par rapport à la tension seuil du transistor diminue et plus une programmation parasite par l'alimentation peut intervenir rapidement. Dans une technologie de 0,35 µm alimentée sous 3,3 volts, on estime qu'une cellule à grille flottante est susceptible d'être programmée de façon parasite par l'alimentation en un an, voire moins. Par conséquent, les critères de fiabilité nécessaires pour un produit industriel sont, dans l'état actuel de la technique, incompatibles avec l'utilisation de cellules à programmation unique à base de transistor à grille isolée.

En outre, les progrès technologiques conduisent à diminuer encore la taille élémentaire dans la fabrication des circuits intégrés, de sorte que le problème de programmation parasite par l'alimentation se produit encore plus rapidement. C'est le cas aujourd'hui avec la technologie de 0,25 µm.

Le document US-A-5602777 décrit un dispositif mémoire à base de cellules constituées de transistors à double grille. Une première grille est laissée flottante tandis qu'une deuxième grille sert de grille de commande. La structure de ce dispositif est une structure différentielle et il comprend un circuit pour éteindre les transistors à grille flottante après avoir stocké leur contenu dans une entité de stockage.

Une telle solution permet de réduire la consommation du dispositif mémoire en limitant les périodes où apparaissent des courants de fuite dans les transistors à grille flottante. Malgré cela, cette solution n'est pas pleinement satisfaisante pour plusieurs raisons.

Tout d'abord, en requérant une commande des transistors à grille flottante, elle impose des transistors à double grille. Par conséquent, elle impose un procédé de fabrication particulier différent d'un simple procédé CMOS.

De plus, il s'agit d'une solution différentielle qui, par conséquent, nécessite deux cellules (deux transistors à grille flottante) pour chaque bit de données.

La présente invention vise à proposer une cellule mémoire à programmation unique à partir d'un transistor à simple grille laissée flottante qui soit compatible avec une faible tension d'alimentation.

La présente invention vise, en particulier, à protéger la cellule mémoire d'une programmation parasite éventuelle par l'alimentation.

La présente invention vise également à proposer une telle cellule mémoire qui reste compatible avec des procédés classiques de fabrication de transistors CMOS.

La présente invention vise également à proposer une solution peu encombrante ne nécessitant qu'une cellule pour chaque bit de données.

Pour atteindre ces objets, la présente invention prévoit une cellule mémoire à programmation unique comportant un seul transistor MOS à simple grille laissée flottante et un moyen de mémorisation temporaire de l'état stocké par le transistor à grille flottante.

L'invention prévoit également un circuit mémoire comprenant des cellules mémoire organisées en structure non-différentielle pour ce qui est des noeuds de stockage des transistors à grille flottante et comprenant des moyens pour fixer l'instant de lecture en fonction des constantes de temps respectives d'établissement des données des cellules programmées et de programmation parasite des cellules à l'état vierge.

Selon un mode de réalisation de la présente invention, l'alimentation du transistor à grille flottante est coupée en dehors de périodes de lecture de l'état qu'il mémorise, ou d'une période de programmation de la cellule.

Selon un mode de réalisation de la présente invention, la mémorisation temporaire de l'état stocké par le transistor à grille flottante est effectuée à chaque mise sous tension du circuit dans lequel est intégrée la cellule mémoire.

Selon un mode de réalisation de la présente invention, le moyen de stockage temporaire comporte un étage, de lecture de l'état mémorisé par le transistor à grille flottante, associé à un registre de stockage de l'état lu.

Selon un mode de réalisation de la présente invention, le registre est commandé, en lecture de l'état présent sur au moins une entrée, par un signal activé lorsque l'étage de lecture présente un état stable sur une sortie.

L'invention prévoit également un procédé de commande d'une cellule mémoire du type comportant un transistor à simple grille laissée flottante, consistant à alimenter le transistor à grille flottante, uniquement pendant des périodes de lecture de l'état de ce dernier ou pendant une période de programmation de l'état de la cellule mémoire.

Selon un mode de réalisation de la présente invention, le procédé consiste à provoquer la lecture de l'état stocké dans la cellule mémoire à chaque mise sous tension du circuit électronique dans lequel elle est intégrée, et à stocker cet état dans un registre de mémorisation temporaire.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2A à 2D qui ont été exposées précédemment sont destinées à exposer l'état de la technique et le problème posé ;
la figure 3 représente, de façon très schématique, un mode de réalisation d'une cellule mémoire à programmation unique selon la présente invention ;
les figures 4A à 4F illustrent, de façon très schématique, le fonctionnement d'une cellule mémoire à programmation unique selon l'invention ;
la figure 5 représente, de façon plus détaillée qu'en figure 3, un mode de réalisation d'une cellule mémoire à programmation unique selon la présente invention ; et
les figures 6A à 6H illustrent, sous forme de chronogrammes, le fonctionnement de la cellule mémoire représentée à la figure 5.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. De plus, on notera que l'invention se réfère à une cellule comprenant un transistor à simple grille, laissée flottante. Par conséquent, au sens de l'invention, un transistor à grille flottante désigne un tel transistor à simple grille isolée (laissée flottante).

Une cellule mémoire selon la présente invention comprend, comme précédemment, un transistor MOS à canal P à grille flottante, monté en série avec au moins un transistor de programmation. Une caractéristique de la présente invention est de couper l'alimentation du transistor à grille flottante en dehors des périodes où la cellule mémoire doit être lue ou programmée. Ainsi, on réduit les périodes pendant lesquelles le transistor à grille flottante reçoit la tension positive d'alimentation et on allonge ainsi la durée de fonctionnement avant laquelle il risque de se produire une programmation parasite de la cellule mémoire.

Une première solution (non représentée) consiste à mettre en oeuvre ce principe de l'invention, uniquement de façon fonctionnelle, c'est-à-dire en appliquant au transistor à grille flottante le potentiel positif d'alimentation à chaque fois que l'on souhaite lire l'état stocké dans la cellule mémoire à programmation unique. Si une telle solution apporte déjà une amélioration par rapport aux cellules mémoire à programmation unique classiques, elle risque de se révéler insuffisante dans le cas de cellules mémoire dont le contenu est lu relativement souvent. En effet, la durée d'exposition du transistor à grille flottante au potentiel positif d'alimentation dépend de la fréquence avec laquelle la cellule mémoire est adressée en lecture. Il en découle que cette solution est, en pratique, limitée à la réalisation de cellules mémoire destinées à n'être lues que très épisodiquement.

De plus, le fait, de commuter l'alimentation de la cellule mémoire à chaque besoin de lecture risque, dans certaines applications, d'allonger la durée des cycles de lecture de manière trop importante par rapport aux autres objectifs de l'application.

Ainsi, une caractéristique d'un mode de réalisation préféré de la présente invention est d'associer un transistor à grille flottante à un registre de stockage temporaire, pour constituer une cellule mémoire à programmation unique protégée d'une programmation parasite éventuelle par l'alimentation.

L'association d'un registre de stockage temporaire de la donnée mémorisée par le transistor à grille flottante permet d'espacer considérablement les lectures de l'état stocké par le transistor à grille flottante et, par voie de conséquence, de retarder de façon optimale l'apparition éventuelle d'une programmation parasite.

Une autre caractéristique de l'invention est que la cellule mémoire est destinée à être implantée dans une structure non-différentielle. Par conséquent, l'invention prévoit de fixer l'instant de lecture des cellules qu'il contient pour garantir l'obtention de données fiables malgré un système monostable (non-différentiel) .

Selon un mode de réalisation préféré de la présente invention, l'état stocké dans le transistor à grille flottante est lu pour être stocké dans le registre temporaire, à chaque mise sous tension du circuit. Par registre de stockage temporaire, on entend au sens de la présente invention un registre ne maintenant pas l'état stocké lorsqu'il n'est pas alimenté.

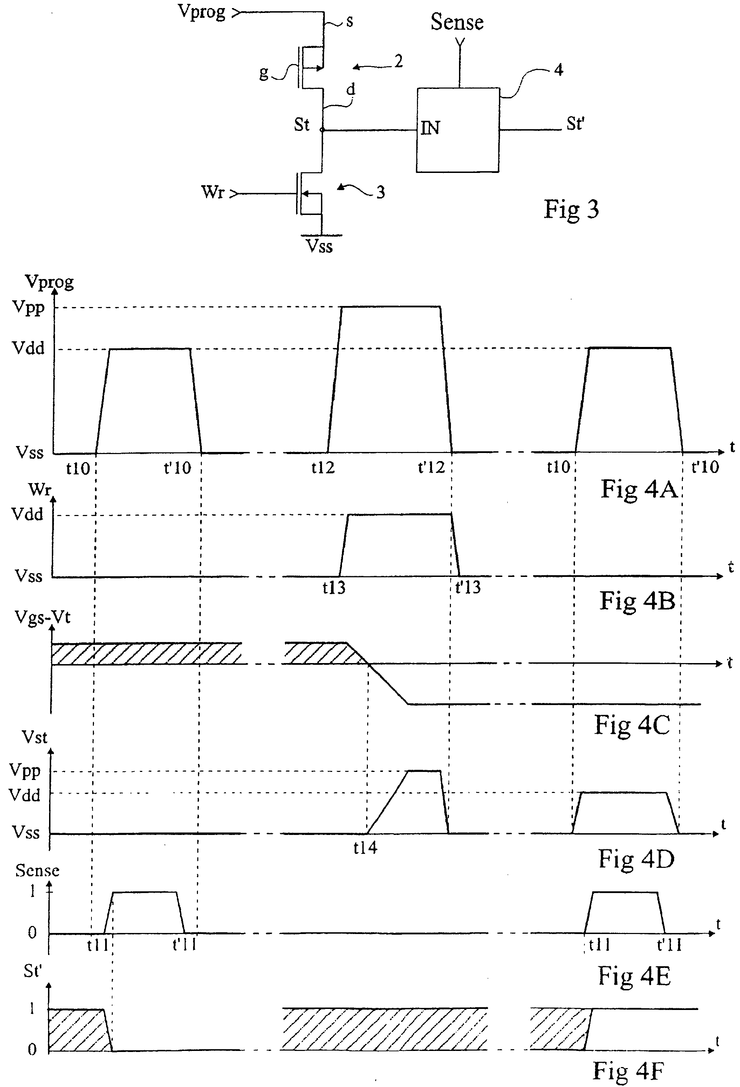

La figure 3 représente, de façon schématique, un premier mode de réalisation d'une cellule mémoire à programmation unique selon la présente invention. Cette cellule comporte, comme une cellule mémoire classique, un transistor 2 à canal P et à grille g flottante, connecté en série avec au moins un transistor 3 de programmation. Le drain d du transistor 2 est relié au drain du transistor 3 et constitue le noeud St de stockage de la donnée non effaçable mémorisée. Le transistor 3 à canal N a sa source reliée à un potentiel Vss négatif d'alimentation, généralement la masse, et sa grille reçoit un signal Wr de programmation de la cellule mémoire.

Selon la présente invention, la source s du transistor à grille flottante 2 est alimentée par un signal Vprog dont le potentiel de repos correspond au potentiel bas Vss d'alimentation du circuit.

Selon la présente invention, le potentiel du signal Vprog est porté au potentiel haut Vdd d'alimentation du circuit pendant les périodes de lecture de l'état stocké au noeud St, et à un potentiel de programmation Vpp excédant le potentiel Vdd pour la programmation de la cellule mémoire à un niveau haut.

Selon le mode de réalisation de l'invention représenté à la figure 3, la cellule mémoire comporte également un registre 4 de stockage temporaire de l'état mémorisé au noeud St. ce registre 4 est destiné à lire un état se présentant sur une entrée IN à l'apparition d'une impulsion sur un signal de commande en lecture (Sense). Une sortie St' du registre 4 constitue la sortie de la cellule mémoire selon la présente invention qui délivre l'état programmé tant que le circuit électronique, auquel cette cellule mémoire est associée, est alimenté.

Les figures 4A à 4F illustrent le fonctionnement d'une cellule mémoire telle que représentée schématiquement à la figure 3. Ces figures représentent, sous forme de chronogrammes, un exemple d'allure de signaux caractéristiques de la cellule pendant trois phases caractéristiques de fonctionnement qui sont la lecture d'un état vierge, la programmation vers un niveau haut et la lecture de l'état programmé de la cellule. La figure 4A représente l'allure de la tension Vprog d'alimentation du transistor à grille flottante 2. La figure 4B représente l'allure du signal Wr. La figure 4C représente l'allure de la tension Vgs-Vt du transistor 2. La figure 4D représente le potentiel Vst du noeud de stockage St. La figure 4E est un exemple d'allure du signal de lecture Sense et la figure 4F indique l'état St' délivré par le registre temporaire 4.

Dans la partie gauche des chronogrammes des figures 4A à 4F, on suppose que la cellule mémoire est dans un état vierge, c'est-à-dire que le transistor à grille flottante 2 n'est pas conducteur. L'état de repos de la cellule mémoire est un signal Vprog au potentiel bas Vss d'alimentation et la tension Vgs-Vt reste positive ou nulle, de sorte que le potentiel du noeud de stockage St correspond au potentiel Vss.

On suppose que le circuit qui contient cette cellule mémoire est mis sous tension. À un instant t10 légèrement postérieur, on effectue selon l'invention, une lecture de l'état stocké dans la cellule mémoire. Pour cela, à l'instant t10, le signal Vprog est porté au potentiel Vdd de manière à permettre la lecture de l'état du transistor 2.

Selon l'invention, l'instant t10 est choisi en fonction de la constante de temps du noeud St de façon à garantir que la donnée lue ait eu le temps de s'établir. L'instant t10 est postérieur à l'instant de mise sous tension d'une durée comprise entre les constantes de temps respectives ctmin et ctmax du noeud St d'une cellule programmée et d'une cellule vierge.

Les constantes ctmin et ctmax correspondent à CSt x R(2), où CSt représente la capacité du noeud St et où R(2) représente la résistance du transistor à grille flottante 2. On notera que seule cette dernière change de façon significative selon l'état de la cellule pour être très importante (tendre vers l'infini) à l'état vierge et de l'ordre de la centaine d'ohms à l'état programmé.

Pour une cellule programmée, la constante de temps correspond au produit de la capacité du noeud St par la résistance à l'état passant du transistor 2. Pour une cellule vierge la constante de temps est égale à CSt x V/Ioff, ou V représente la tension aux bornes du transistor 2 et où Ioff représente son courant de fuite à l'état bloqué. On notera que la capacité du noeud St est fonction de la capacité d'entrée du registre 4.

À un instant t11 (figure 4E) légèrement postérieur, on active la lecture, par le registre 4, de l'état présent sur son entrée IN en plaçant le signal Sense dans un état actif. Par soucis de clarté, on a symbolisé par des états "0" et "1", les états respectivement actif et inactif du signal Sense. À l'instant t11, l'état bas (Vss) du noeud St est reporté en sortie St' du registre 4 . L'échelon d' activation du registre 4 se termine à un instant t'11 dont la durée est, bien entendu, choisie pour être compatible avec la propagation des signaux dans le registre 4. Une fois que le signal de lecture de l'entrée du registre 4 est redevenu à son état inactif, l'alimentation du transistor à grille flottante peut être coupée (instant t'10) dans la mesure où l'état non effaçable de la cellule reste disponible sur la borne St' tant que l'alimentation générale du circuit n'est pas coupée.

La partie centrale des chronogrammes des figures 4A à 4F illustrent une autre phase de fonctionnement qui correspond à la programmation de la cellule. Cette phase de programmation intervient alors que la cellule est vierge dans la mesure où la cellule ne peut être programmée électriquement qu'une seule fois.

La programmation d'une cellule mémoire selon l'invention est similaire à la programmation d'une cellule classique telle que représentée à la figure 1. On applique un échelon de tension à un potentiel de programmation Vpp sur la source s du transistor à grille flottante 2 (instants t12, t'12, figure 4A). A un instant t13, postérieur à l'instant t12, on porte le signal de programmation Wr au potentiel Vdd de manière à rendre le transistor 3 conducteur. L'accumulation d'électrons "chauds" dans la grille du transistor 2 conduit à rendre sa tension Vgs-Vt négative de sorte que le transistor 2 devient passant. Dès que la tension Vgs-Vt devient négative, la tension Vst du noeud de stockage croît (instant t14) jusqu'à atteindre le potentiel Vpp.

Selon l'invention, à l'instant t'12, où le signal Vprog revient vers son état de repos (Vss), le potentiel Vst du noeud de stockage est également ramené au potentiel Vss. Ainsi, une fois programmé, le transistor à grille flottante 2 n'est plus alimenté de sorte qu'il ne risque pas de subir une programmation parasite par son alimentation. Comme précédemment, à un instant t'13 postérieur à l'instant t'12, le signal de programmation Wr est ramené à l'état bas (Vss).

La partie droite des chronogrammes des figures 4A à 4F illustre la lecture, par exemple lors de la mise sous tension du circuit ou après la programmation de la cellule, d'une cellule programmée selon l'invention. L'allure des signaux Vprog et Sense est identique à celle exposée en relation avec la partie gauche des chronogrammes, c'est-à-dire avec la lecture d'une cellule vierge. Toutefois, dans le cas d'une cellule programmée, entre les instants t10 et t'10 où le signal Vprog est porté au potentiel Vdd, le potentiel vst suit cette valeur et est donc également au potentiel Vdd. Il en découle qu'à l'instant t11, où le signal Sense déclenche le stockage dans le registre 4 de la valeur présente sur son entrée IN, cette valeur est à l'état haut. Par conséquent, le registre 4 mémorise cet état et délivre un état haut sur sa sortie St'. Comme dans le cas d'une lecture d'une cellule vierge, une fois que cet état est mémorisé dans le registre 4, c'est-à-dire à partir de l'instant t'11, l'alimentation du transistor à grille flottante 2 peut être coupée de manière à empêcher l'apparition d'électrons chauds et éviter ainsi toute programmation parasite.

On notera que l'application d'un échelon de tension Vdd sur le signal Vprog lors de la lecture de la cellule vierge n'est pas indispensable pour stocker temporairement le bon état. Toutefois, cet échelon est appliqué dans la mesure où l'on ne connaît pas à l'avance l'état de la cellule.

Un avantage de l'invention est qu'elle minimise les périodes pendant lesquelles le transistor à grille flottante est alimenté et, par voie de conséquence, les périodes pendant lesquelles la grille de ce transistor accumule des électrons. En prévoyant une alimentation du transistor à grille flottante à chaque mise sous tension du circuit dans lequel est intégrée la cellule mémoire, on empêche en pratique toute programmation parasite même pour une cellule mémoire réalisée dans une technologie à faible tension d'alimentation.

On notera que, comme dans le cas d'une cellule mémoire à programmation unique classique utilisant un transistor à grille flottante, l'effacement de la cellule ne peut pas être effectué électriquement et nécessite un recuit ou, le cas échéant, une exposition à des rayons ultraviolets pour évacuer les électrons de la grille.

Tout registre programmable de stockage temporaire peut être utilisé en relation avec un transistor à grille flottante pour obtenir une cellule mémoire selon l'invention, pourvu de respecter les conditions fonctionnelles d'alimentation du transistor à grille flottante décrites ci-dessus.

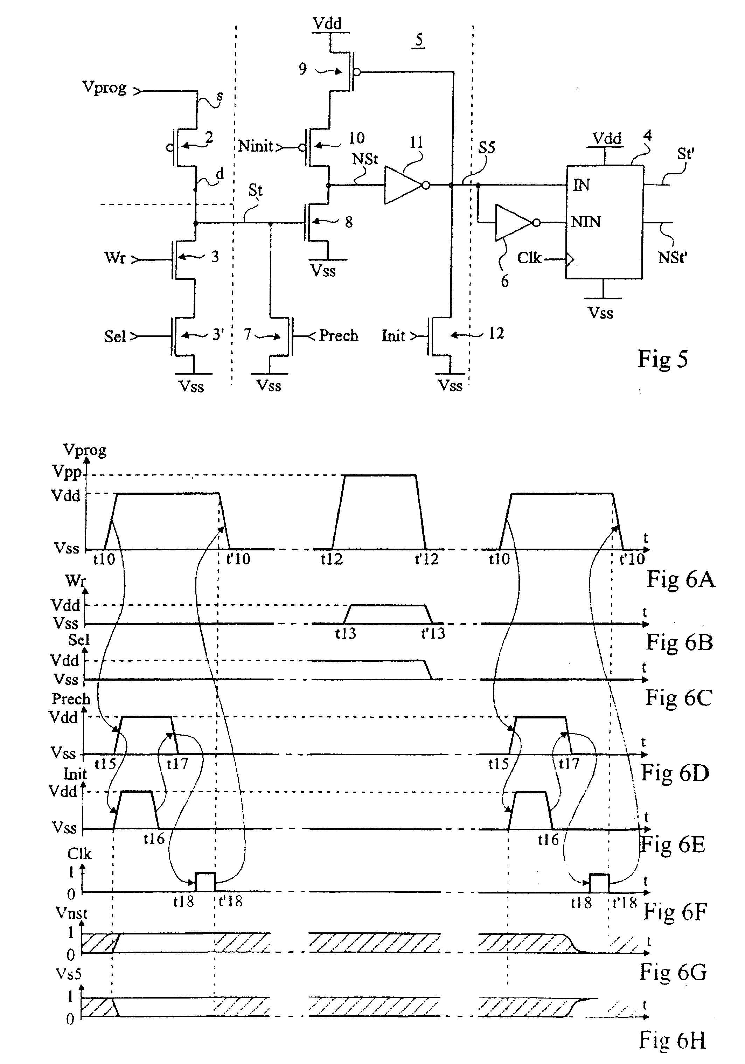

La figure 5 représente un mode de réalisation d'une cellule mémoire de l'invention illustrant un mode de réalisation préféré d'un étage 5 de lecture de l'état stocké par le transistor à grille flottante 2 pour sa mémorisation dans un registre de stockage temporaire 4. Le mode de réalisation de la figure 5 reprend les principes exposés en relation avec la figure 3, mais représente un schéma plus détaillé.

Ainsi, la cellule de la figure 5 comprend toujours un transistor 2 à grille flottante monté en série avec une structure de programmation. Toutefois, dans le mode de réalisation illustré par la figure 5, cette structure de programmation est constituée de deux transistors MOS à canal N 3 et 3', montés en série entre le drain d du transistor 2 et le potentiel bas d'alimentation Vss. Le transistor 3 reçoit sur sa grille le signal de programmation Wr, tandis que le transistor 3' constitue un transistor de sélection recevant un signal Sel sur sa grille. Une structure de programmation et de sélection telle que représentée à la figure 5 constitue une structure classique pour constituer, associée à un transistor à grille flottante, une cellule mémoire à programmation unique. Pour une seule cellule, cela revient sensiblement au même que les structures simplifiées décrites précédemment. Le transistor de sélection 3' sert essentiellement à la sélection d'une cellule à programmer dans un réseau de cellules mémoire recevant toutes le même signal de programmation Wr.

La source s du transistor 2 reçoit, comme dans le mode de réalisation précédent, un signal Vprog d'alimentation dont le potentiel est fonction de la phase de fonctionnement dans laquelle se trouve cette cellule mémoire. Le noeud de stockage St, correspondant au drain d du transistor à grille flottante 2, est relié à l'entrée d'un étage de lecture 5, intermédiaire entre le transistor 2 et un registre de stockage 4 proprement dit.

Dans l'exemple représenté à la figure 5, on a indiqué que le registre 4 est alimenté par les potentiels Vdd et Vss d'alimentation du circuit dans lequel est intégrée la cellule mémoire. Ce registre 4 reçoit un signal Clk, activé, par exemple à l'état haut, pour provoquer la mémorisation de l'état présent sur ses entrées non inversée IN et inversée NIN. Le registre 4 comporte deux bornes de sorties St' et NSt' correspondant à l'état mémorisé, respectivement, non inversé et inversé. Un exemple de structure de registre de stockage temporaire 4 de ce type est décrit, par exemple, dans la demande de brevet français n°2725824. Une sortie S5 de l'état de lecture 5 est reliée directement à la borne IN et, par l'intermédiaire d'un inverseur 6, à la borne NIN du registre 4.

Dans l'exemple représenté à la figure 5, l'étage de lecture 5 est un montage à transistors, propre à reporter l'état mémorisé au noeud de stockage St sur les entrées du registre 4. Ce montage à transistors comprend un transistor 7 à canal N, dit de lecture, connecté entre le noeud St et le potentiel bas Vss d'alimentation. Le transistor 7 reçoit un signal de commande Prech, dit de précharge de lecture. Le noeud St est également relié à la grille d'un transistor MOS 8 à canal N dont la source est reliée au potentiel Vss et dont le drain est relié, par l'intermédiaire de deux transistors MOS 9, 10 à canal P connectés en série, au potentiel haut Vdd d'alimentation. Le drain commun des transistors 8 et 10 constitue un noeud NSt relié, par l'intermédiaire d'un inverseur 11, à la borne S5 de sortie de l'étage de lecture 5. Cette borne S5 est également reliée à la base du transistor 9 et, par l'intermédiaire d'un transistor à canal N 12, au potentiel Vss. La base du transistor 12 reçoit un signal Init, dit de déclenchement de lecture, et la base du transistor 10 reçoit l'inverse Ninit de ce signal Init. Le noeud NSt constitue, dans cet étage de lecture 5, un noeud flottant reproduisant l'inverse de l'état mémorisé au noeud St.

Le fonctionnement d'un étage de lecture tel qu'illustré par la figure 5 est décrit en relation avec les figures 6A à 6H qui représentent, sous forme de chronogrammes, un exemple d'allures de signaux caractéristiques du schéma de la figure 5 dans trois phases de fonctionnement correspondant, respectivement, à une lecture d'une cellule mémoire vierge, à une programmation de cette cellule et à une lecture de la cellule mémoire programmée. Les figures 6A, 6B et 6C représentent, respectivement, l'allure des signaux Vprog, Wr et Sel. Les figures 6D et 6E représentent, respectivement, l'allure des signaux Prech et Init de commande de l'étage de lecture 5. On notera que le signal Ninit (non représenté) appliqué sur la grille du transistor 10 correspond à l'inverse du signal Init. La figure 6F représente le signal Clk de commande du registre de stockage temporaire 4. Les figures 6G et 6H représentent, respectivement, les potentiels Vnst et Vs5 aux noeuds respectifs Nst et S5.

Dans la partie gauche des chronogrammes des figures 6A à 6H, on suppose que la cellule à programmation unique est dans un état vierge, c'est-à-dire que le transistor 2 est bloqué. Comme dans le cas de la figure 3, le potentiel de repos du signal Vprog est le potentiel Vss, de sorte que le transistor à grille flottante 2 n'est pas alimenté en dehors des périodes où cela est nécessaire pour sa lecture ou sa programmation. À un instant t10, le signal Vprog est commuté vers le potentiel Vdd de façon à enclencher un cycle de lecture de la cellule mémoire. Les signaux Wr et Sel sont tous deux à l'état bas (Vss) dans la mesure où il ne s'agit pas d'un cycle de programmation.

À un instant t15, postérieur à l'instant t10, on déclenche la lecture par une mise en conduction du transistor 7 sous l'effet d'un passage du signal Prech du potentiel Vss vers le potentiel Vdd. Au même instant t15, le signal Init est commuté vers l'état haut (Vdd) de façon à rendre le transistor 12 également passant. Le signal Ninit passe quant à lui à l'état bas de sorte qu'il rend le transistor à canal P 10 également passant.

La mise en conduction du transistor 7 abaisse le potentiel du noeud St, de même que la mise en conduction du transistor 12 amène un potentiel bas (Vss) sur le noeud de sortie S5 de l'étage 5. Le transistor 9 devient donc passant, et, comme le transistor 10 est passant, le noeud NSt se trouve au potentiel Vdd. En effet, le transistor 8 reste bloqué dans la mesure où sa grille est sensiblement au potentiel Vss.

À un instant t16, on commence à relâcher les signaux de commande de l'étage de lecture, c'est-à-dire que le signal Init est commuté vers son état de repos (Vss), ce qui a pour conséquence de bloquer le transistor 12 et, par le signal Ninit, le transistor 10. À un instant t17, postérieur ou simultané à l'instant t16, on relâche le signal Prech de sorte que le transistor 7 se bloque. Comme le transistor 10 est également bloqué, le drain commun des transistors 8 et 10 qui constitue le noeud NSt est flottant, c'est-à-dire qu'il est isolé des lignes d'alimentation. Le potentiel Vnst reste donc au potentiel Vdd. Par l'inverseur 11, le drain du transistor 12, c'est-à-dire le noeud S5 reste à l'état bas, ce qui est compatible avec l'état de blocage du transistor 12, de sorte que l'état ainsi lu est stable pour permettre l'enregistrement de la valeur dans le registre 4.

À un instant t18, postérieur à l'instant t17, on active la mémorisation de la valeur présente aux entrées IN et NIN du registre 4 par la mise à l'état haut du signal Clk. L'état bas du noeud S5 est donc mémorisé par le registre 4. À la fin (instant t'18) de l'échelon de commande du signal Clk, choisi pour permettre la mémorisation sûre de l'état dans le registre 4 en tenant compte des différents intervalles de commutation, on peut faire disparaître l'alimentation du transistor à grille flottante 2 jusqu'à la prochaine mise sous tension du circuit (ou sa réinitialisation) ou jusqu'à la programmation de la cellule. Après l'instant t'18, l'évolution des potentiels Vnst et Vs5 n'a plus aucune incidence sur le registre de mémorisation temporaire 4.

La partie centrale des chronogrammes des figures 6A à 6H illustre un cycle de programmation de la cellule mémoire. Ce cycle est similaire à celui illustré aux figures 4A à 4D et les tensions Vgs-Vt et Vst n'ont pas été représentées de nouveau. La figure 6C illustre que le transistor 3' est rendu conducteur, au moins pendant toute la période t12-t'13 nécessaire à la programmation. Dans l'exemple représenté, le transistor de sélection 3' est rendu conducteur par une mise au niveau haut (Vdd) du signal Sel préalablement à l'instant t12 auquel le signal Vprog passe au potentiel de programmation Vpp.

On notera que la croissance du potentiel du noeud St pendant la programmation est sans conséquence sur la suite du circuit, dans la mesure où, même si le transistor 8 est rendu passant, l'état bloqué du transistor 10 par l'absence de signal de commande de l'étage de lecture 5 empêche la propagation de cet état. En outre, aucune commande en mémorisation d'état n'est adressée au registre 4.

La partie droite des chronogrammes des figures 6A à 6H illustre un cycle de lecture de l'état mémorisé par la cellule représentée en figure 5, dans le cas où cette cellule est programmée.

L'allure des signaux Prech, Init, Clk, Vprog étant indépendante de l'état de la cellule, la partie droite des chronogrammes des figures 6A, 6D, 6E et 6F reprend l'allure exposée en relation avec la partie gauche (instants t10, t'10, t15, t16, t17, t18, t'18).

Toutefois, à l'instant t17 où le transistor 7 est rendu bloqué par le signal Prech, le potentiel du noeud St (non représenté), initialement forcé (instant t15) au potentiel Vss, croît vers le potentiel Vdd en suivant la forme d'une charge d'un élément capacitif de sorte que le transistor 8 devient passant. Il en découle que le potentiel Vnst passe à "0" et, par voie de conséquence, le potentiel Vs5 passe à l'état "1" en sortie de l'inverseur 11. Le transistor 9 est alors bloqué de sorte que l'état haut du noeud NSt est stable le temps d'en effectuer la mémorisation par le registre temporaire 4. On peut alors déclencher la mémorisation de l'état au noeud S5 par le signal Clk. Après l'instant t'18, choisi pour laisser au registre 4 le temps de mémoriser la valeur au noeud S5, on peut couper l'alimentation du transistor à grille flottante 2 (instant t'10). On notera que l'instant t18 est retardé d'une valeur suffisante par rapport à l'instant t17 pour laisser aux signaux Nst et S5 le temps de se stabiliser. Cela va dans le sens de garantir la fiabilité des données lues et correspond aux temps d'établissement des données aux noeuds du circuit comme cela a été indiqué précédemment. Un tel choix des instants de lecture permet d'éviter le recours à une structure différentielle (bistable).

La valeur mémorisée par le registre 4 reste présente en sorties St' et NSt' jusqu'à l'extinction du circuit, c'est-à-dire jusqu'à ce que l'on coupe l'alimentation du registre 4.

Un avantage de la présente invention est que la cellule mémoire est protégée contre une programmation parasite par son alimentation.

Un avantage d'effectuer une mémorisation dans un registre temporaire, qui ne peut changer d'état que sur commande par le signal Clk ou en cas de disparition de l'alimentation générale du circuit dans lequel est implantée la cellule mémoire, est que la fiabilité de la cellule est rendue sensiblement indépendante de la fréquence de lecture de la donnée qu'elle mémorise. On veillera toutefois à ce qu'en cas de programmation de la cellule de l'invention, un nouveau cycle de lecture de l'état mémorisé par le transistor à grille flottante soit déclenché sans attendre la prochaine mise sous tension du circuit.

Un avantage d'effectuer une lecture à chaque mise sous tension est que les cycles de lecture ultérieurs du circuit sous tension ne sont pas perturbés par la commutation du signal Vprog.

La réalisation du registre de mémorisation temporaire 4 est à la portée de l'homme du métier en fonction des indications fonctionnelles données ci-dessus. On notera que même si le registre est de structure différentielle, le point mémoire St de l'invention reste non-différentiel.

Bien entendu, la présente invention est susceptible de diverses variantes et modifications qui apparaîtront à l'homme de l'art. En particulier, on pourra utiliser tout système de lecture et de mémorisation temporaire de l'état stocké dans le transistor à grille flottante, pourvu de respecter la caractéristique de l'invention qui consiste à couper l'alimentation de ce transistor à grille flottante en dehors des périodes où cette alimentation est utile pour sa lecture ou sa programmation. A cet égard, d'autres périodes de lecture que la mise sous tension pourront être prévues. Elles seront toutefois, de préférence, les plus espacées possible.

De plus, les dimensions respectives des différents transistors utilisés pour concevoir une cellule à programmation unique selon l'invention sont à la portée de l'homme du métier en fonction des contraintes fonctionnelles de cette cellule. On notera ici que l'invention ne nécessite pas de procédé de fabrication de transistor particulier, comme c'est le cas pour une EEPROM ou pour un transistor à double grille, et se contente d'un procédé CMOS.

## Revendications

1. Cellule mémoire à programmation unique du type comportant un seul transistor MOS à simple grille, laissée flottante (2), **caractérisée en ce qu'**elle comporte un moyen (4) de mémorisation temporaire de l'état stocké par le transistor à grille flottante, l'alimentation du transistor à grille flottante (2) étant coupée en dehors de périodes (t10, t'10) de lecture de l'état qu'il mémorise, ou d'une période de programmation (t12, t'12) de la cellule.

2. Cellule mémoire selon la revendication 1, **caractérisée en ce que** la mémorisation temporaire de l'état stocké par le transistor à grille flottante (2) est effectuée à chaque mise sous tension du circuit dans lequel est intégrée la cellule mémoire.

3. Cellule mémoire selon la revendication 1 ou 2, **caractérisée en ce que** le moyen de stockage temporaire comporte un étage (5), de lecture de l'état mémorisé par le transistor à grille flottante (2), associé à un registre (4) de stockage de l'état lu.

4. Cellule mémoire selon la revendication 3, **caractérisée en ce que** le registre (4) est commandé, en lecture de l'état présent sur au moins une entrée (IN, NIN), par un signal (Clk) activé lorsque l'étage de lecture (5) présente un état stable sur une sortie (S5).

5. Circuit mémoire comprenant des cellules mémoire conformes à l'une quelconque des revendications 1 à 4, **caractérisé en ce qu'**il comporte des moyens propres à fixer un instant de lecture des états respectifs stockés par les cellules pour mémorisation temporaire, en fonction des constantes de temps respectives des cellules selon leur état vierge ou programmé.

6. Procédé de commande d'une cellule mémoire du type comportant un seul transistor à simple grille, laissée flottante (2), **caractérisé en ce qu'**il consiste :
- à alimenter le transistor à grille flottante, uniquement pendant des périodes de lecture (t10, t'10) de l'état de ce dernier ou pendant une période de programmation (t12, t'12) de l'état de la cellule mémoire ;
- à provoquer la lecture de l'état stocké dans la cellule mémoire à chaque mise sous tension du circuit électronique dans lequel elle est intégrée, et à stocker cet état dans un registre (4) de mémorisation temporaire, l'instant de lecture étant choisi postérieurement à l'instant de mise sous tension d'une durée supérieure au temps d'établissement de l'état d'une cellule programmée et inférieure à la constante de temps d'une cellule à l'état vierge.

## Patentansprüche

1. Eine einmalig programmierbare Speicherzelle einschließlich eines MOS Transistors (2) mit einem einzigen Gate in einem schwimmenden oder floating Zusand, **dadurch gekennzeichnet, dass** Folgendes vorgesehen ist: Mittel (4) zur temporären Speicherung des durch den Floating-Gate-Transistor gespeicherten Zustands, wobei die Leistungsversorgung des Floating-Gate-Transistors (2) außerhalb der Perioden (t10, t'10) des Lesens des Zustands das er speichert, oder einer Zellenprogrammierperiode (t12, t'12), unterbrochen ist.

2. Speicherzelle nach Anspruch 1, **dadurch gekennzeichnet, dass** die temporäre Speicherung des in dem Floating-Gate-Transistor (2) gespeicherten Zustands, jedesmal bei der Leistungsversorgung bzw. dem Einschalten der Schaltung ausgeführt wird, in der die Speicherzelle integriert ist.

3. Speicherzelle nach Anspruch 1 oder 2, **dadurch gekennzeichnet, dass** die temporären Speichermittel eine Stufe (5) zum Lesen des durch den Floating-Gate-Transistor (2) gespeicherten Zustands, assoziiert mit einem Register (4) zum Speichern des gelesenen Zustands aufweisen.

4. Speicherzelle nach Anspruch 3, **dadurch gekennzeichnet, dass** das Register (4) beim Lesen des an mindestens einem Eingang (IN, NIN) vorhandenen Zustands durch ein Signal (Clk) gesteuert wird, und zwar aktiviert, wenn der Lesezustand (5) einen Stetigzustand an einem Ausgang (S5) zeigt.

5. Speicherschaltung mit Speicherzellen nach einem der Ansprüche 1 bis 4, **dadurch gekennzeichnet, dass** Mittel vorgesehen sind, zum Setzen oder Einstellen einer Lesezeit der entsprechenden, durch die Zellen gespeicherten Zustände, und zwar zur temporären Speicherung als eine Funktion der entsprechenden Zeitkonstanten der Zellen, entsprechend ihrem leeren oder programmierten Zustand.

6. Verfahren zur Steuerung einer Speicherzelle der Bauart mit einem einzigen Transistor (2), mit einem einzigen Gate in einem Floating-Zustand, **dadurch gekennzeichnet, dass** das Verfahren Folgendes vorsieht:
Versorgung des Floating-Gate-Transistors nur während Perioden des Lesens (t10, t'10) des Zustandes desselben oder während einer Periode des Programmierens (t12, t'12) des Zustands der Speicherzelle;
Bewirken des Lesens des in der Speicherzelle gespeicherten Zustands bei jedem Einschalten der elektronischen Schaltung, in der die Speicherzelle integriert ist, und Speichern dieses Zustands in einem temporären Speicherregister (4), wobei die Lesezeit nach dem Einschalten durch eine Dauer größer als die Einstellzeit einer programmierten Zelle und kleiner als die Zeitkonstante einer Zelle im leeren Zustand gewählt wird.

## Claims

1. A one-time programmable memory cell including one MOS transistor (2) with a single gate, in a floating state **characterized in that** it comprises means (4) for temporary storing of the state stored by the floating-gate transistor, the power supply of the floating-gate transistor (2) being interrupted outside periods (t10, t'10) of reading the state that it stores, or a cell programming period (t12, t'12).

2. The memory cell of claim 1, **characterized in that** the temporary storage of the state stored by the floating-gate transistor (2) is performed upon each powering-on of the circuit in which the memory cell is integrated.

3. The memory cell of claim 1 or 2, **characterized in that** the temporary storage means includes a stage (5), for reading the state stored by the floating-gate transistor (2), associated with a register (4) for storing the read state.

4. The memory cell of claim 3, **characterized in that** the register (4) is controlled, in the reading of the state present on at least one input (IN, NIN), by a signal (Clk) activated when the read stage (5) exhibits a steady state on one output (S5).

5. A memory circuit comprising memory cells according to any of claims 1-4, **characterized in that** it comprises means for setting a read time of the respective states stored by the cells, for temporary storage, as a function of the respective time constants of the cells according to their blank or programmed state.

6. A method of controlling a memory cell of the type including a single transistor (2) with a single gate, in a floating state **characterized in that** it consists of:
supplying the floating-gate transistor, only during periods of reading (t10, t'10) the state thereof or during a period of programming (t12, t'12) the state of the memory cell;
causing the reading of the state stored in the memory cell upon each powering-on of the electronic circuit in which it is integrated, and of storing this state in a temporary storage register (4), the read time being selected after the powering-on by a duration greater than the setting time of a programmed cell and smaller than the time constant of a cell at the blank state.
